# EUROPEAN PATENT APPLICATION

(11) **EP 4 783 815 A1**
(43) Date of publication of application: **29.07.2026**
(21) Application number: 26152527.3
(22) Date of filing: 19.01.2026
(51) Int. Cl.: H10W 40/47, H10W 40/00, H10W 40/60

(54) **COLD PLATE**

(30) Priority: 23.01.2025 KR 20250010570; 15.12.2025 KR 20250199621
(71) Applicant: LG Electronics Inc., Yeongdeungpo-gu Seoul 07336 (KR)
(72) Inventor: PARK, Jungsik, 07796 Seoul (KR); LEE, Jungsoo, 07796 Seoul (KR); OH, Honglyeol, 07796 Seoul (KR); CHANG, Hyeuk, 07796 Seoul (KR); SEONG, Daeyong, 07796 Seoul (KR); JEONG, Sehwan, 07796 Seoul (KR)
(74) Representative: Vossius & Partner Patentanwälte Rechtsanwälte mbB

(57) **Abstract**

Provided is an embodiment of a cold plate in which a side passage is arranged along a side of an inside thereof, a plurality of cooling fins are arranged at predetermined intervals in a region excluding the side passage, and a plurality of cooling passages are arranged the predetermined intervals, respectively.

## Description

### BACKGROUND

### Field

The present disclosure relates to a water-cooled cold plate.

### Description of the Related Art

The technology underlying the present disclosure relates to a cold plate for a chipset.

A heat sink constituting the cold plate is a type of heat exchanger that has materials and structures specialized for heat conduction and radiation, and plays a role of taking heat from a system that generates heat and releasing the heat to the surroundings. A heat sink is designed to maximize surface area for effective heat dissipation, and have a plurality of heat dissipation fins for this purpose.

The heat sink must dissipate as much heat as possible over a large surface area, and thus can be made of a lightweight material with excellent thermal conductivity. For this purpose, the most widely used heat sink is aluminum alloy. Although copper has better thermal conductivity, it is not widely used because it is much heavier and more expensive than aluminum. Sometimes, a portion that comes into direct contact with a heat generating component is made of copper, and a heat dissipation plate/ heat dissipation fin portion surrounding it is made of aluminum alloy.

With recent industrial developments, highly integrated circuits are utilized in limited spaces in various electrical and electronic devices, which use electrical energy and convert the remaining energy into heat sources to generate a lot of heat. Such excessive heat generation can cause extreme performance degradation or failure of electrical and electronic devices. Accordingly, the improvement of the performance of heat sinks that dissipate heat to the outside is emerging as an issue.

Meanwhile, as one of the conventional technologies for manufacturing such a heat sink, Korean Patent Publication No. 10-2023-0120838 (hereinafter referred to as "prior art document") discloses a technology for manufacturing a heat sink by a skiving method. The skiving method is a method of forming fins by cutting a heat sink base with a cutting blade and then raising it in a vertical direction, in which each fin is processed and molded, and then covered. In this way, inside the sealed cover, a gap between the fins forms a passage, and coolant flows through the passage to cool the heat of the fins.

The technology disclosed in the prior art document makes mass production impossible because a single manufacturing device can only manufacture one heat sink at a time, and requires several post-processing operations such as molding and covering to make the process complicated so as to increase the probability of occurrence of defects or deteriorate its quality in this complicated process. In addition, a fin cut by the cutting blade is manufactured in a manner of raising it vertically, and thus the fin is more likely to bend or come into contact with a fin adjacent thereto as increasing a height of the fin, which limits the formation of the height of the fin. The height of the fin in a heat sink is a major factor capable of lowering the thermal resistance (helping heat diffusion), and the technology disclosed in the prior art document, which has a limited height of the fin, also has a limitation in cooling performance.

That is, in the conventional technology, a plurality of heat sinks cannot be manufactured, a lot of time and costs are required to manufacture, and there is a limitation in that there is a risk of defects due to a number of post-processes, and cooling performance is inevitably limited.

### SUMMARY

An aspect of the present disclosure is intended to improve the foregoing limitations of the related art.

Accordingly, this specification is intended to provide an embodiment capable of improving cooling efficiency.

In addition, this specification is intended to provide an embodiment that can be manufactured using a simplified process.

Furthermore, this specification is intended to provide an embodiment that is capable of mass production.

In order to solve the foregoing problems, the present disclosure provides a solution by forming a side passage around a cooling fin so as to allow coolant passing through the cooling fin to be circulated through the side passage.

Specifically, a heat sink can have a structure in that a side passage is formed along a side of an inside thereof, a plurality of cooling fins are arranged at predetermined intervals in a region excluding the side passage, and a plurality of cooling passages are formed at the predetermined intervals, respectively.

Such technical features can be applied and implemented to a heat sink, a method of manufacturing the heat sink, a cold plate including the heat sink, and a method of manufacturing the cold plate, and this specification is intended to provide an embodiment of the cold plate according to the technical features.

An embodiment of the cold plate can include an inlet arranged on one surface through which coolant flows in, an outlet arranged on the one surface through which the coolant flows out, and a cooling part arranged in an internal space thereof through which the coolant flows to exchange heat, wherein the cooling part includes a side passage arranged along a side of an inside thereof, a plurality of cooling fins arranged at predetermined intervals in a region excluding the side passage, and a plurality of cooling passages arranged at the predetermined intervals, respectively.

In an embodiment, the one surface can be a surface opposite to a surface with which a cooling target comes into contact.

In an embodiment, the one surface can be one of surfaces having a largest area.

In an embodiment, the inlet can be arranged at a position corresponding to one of the side passage and a central portion of the cooling part.

In an embodiment, the inlet can be arranged on one of one end side and a center side of the one surface.

In an embodiment, the outlet can be arranged at a position corresponding to that of the side passage.

In an embodiment, the inlet can be arranged on one or more of one end side and the other end side of the one surface.

In an embodiment, first, second, and third plates processed in different shapes can be respectively formed by stacking them in plurality in a predetermined order.

In an embodiment, a portion of each of long sides and each of short sides can be formed by stacking the first plate.

In an embodiment, a portion of each of the plurality of cooling passages and each of the short sides can be formed by stacking the second plate.

In an embodiment, a portion of each of the plurality of cooling fins and each of the short sides can be formed by stacking the third plate.

In an embodiment, the side passage can have one passage extending along the side.

In an embodiment, the side passage can be arranged to have a larger width than the plurality of cooling passages.

In an embodiment, the plurality of cooling fins can be arranged to have a thickness of 0.1 to 2.0 [mm].

In an embodiment, the plurality of cooling fins can be arranged to have a width of 1 to 20 [mm].

In an embodiment, the plurality of cooling fins can be arranged at intervals of 0.1 to 5.0 [mm].

In an embodiment, in the cooling part, cooling fins arranged at uppermost and lowermost ends respectively can build partitions in a length direction so as to separate between an inner side of the partition and the side passage.

In an embodiment, the cooling part can further include a central passage arranged along a central axis of the cooling fins arranged between uppermost and lowermost ends of the plurality of cooling fins by passing through the central axis.

In an embodiment, the central passage can be arranged to have a larger width than the plurality of cooling passages.

In an embodiment, in the cooling part, when the coolant flows therein, the coolant can flow through the central passage, branch off into the plurality of cooling passages, respectively, and then flow into the side passage.

The foregoing embodiment of the cold plate are not limited to those described above, and can also include embodiments that can be described in the detailed description below or inferred/derived from the detailed description.

According to the foregoing embodiment of a cold plate, a side passage can be formed around a cooling fin so as to allow coolant passing through the cooling fin to be circulated through the side passage, thereby having an effect capable of maximizing a surface area through which the coolant flows as well as evenly distributing heat.

Accordingly, there is an effect capable of improving the cooling efficiency as well as uniformly maintaining the temperature inside the cold plate.

In addition, a passage can be formed through a stacked manufacturing process, thereby having an effect capable of manufacturing and use without a separate process for arranging the passage.

Furthermore, a process for forming and using the passage can be omitted to simplify the process, thereby reducing the time and cost consumed in the manufacturing process.

The effects according to the foregoing embodiment of the cold plate are not limited to those described above, and can also include effects that can be described in the detailed description below or inferred/derived from the detailed description.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic view of a cold plate;
FIG. 2 is a cross-sectional view of a cooling part of a cold plate;
FIG. 3 is an exemplary view of a plurality of plates constituting a cold plate;
FIG. 4 is an exemplary view showing a stacked structure of a cold plate;
FIG. 5 is a perspective view of a cooling part of a cold plate;
FIG. 6 is a cross-sectional view of the cold plate shown in FIG. 5;
FIG. 7 is an exemplary view of an inlet and an outlet according to an example of the cooling part shown in FIG. 5;
FIG. 8 is an exemplary view showing a flow of coolant according to an example of the inlet and the outlet shown in FIG. 7;
FIG. 9 is an exemplary view showing another example of a third plate among a plurality of plates of a cold plate;
FIG. 10 is a perspective view of a cooling part according to an example of the third plate shown in FIG. 9;
FIG. 11 is a cross-sectional view of the cold plate shown in FIG. 10;
FIG. 12 is an exemplary view of an inlet and an outlet according to an example of the cooling part shown in FIG. 10;
FIG. 13 is an exemplary view showing a flow of coolant according to an example of the inlet and the outlet shown in FIG. 12;
FIG. 14 is another exemplary view of an inlet and an outlet according to an example of the cooling part shown in FIG. 10;
FIG. 15 is an exemplary view showing a flow of coolant according to another example of the inlet and the outlet shown in FIG. 14;
FIG. 16 is an exemplary view showing nipples arranged at an inlet and an outlet, respectively, of a cold plate;
FIG. 17 is an exemplary view of a bracket mounted on a top of a cold plate;
FIG. 18 is an exemplary view of the bracket shown in FIG. 17 mounted on the cold plate shown in FIG. 16;
FIG. 19 is an exemplary view of a plurality of plates for manufacturing a plurality of cold plates;
FIG. 20 is an exemplary view showing a process of stacking the plurality of plates shown in FIG. 19;
FIG. 21 is an exemplary view showing a bonding process subsequent to the stacking process shown in FIG. 20; and
FIG. 22 is an exemplary view showing a cutting process subsequent to the bonding process shown in FIG. 21.

### DETAILED DESCRIPTION OF THE EMBODIMENTS

Hereinafter, an embodiment of a cold plate will be described in detail with reference to the accompanying drawings, but in order to clearly describe the features of the present disclosure, the contents corresponding to the general technical matters of the technical field disclosed in the prior art document as mentioned above, descriptions of some well-known and obvious elements, matters that can be understood by those skilled in the art even if a specific description is omitted, or matters that can be sufficiently predicted/derived and understood from the contents to be described below will be omitted.

A cold plate according to an embodiment can be implemented by a water-cooled heat sink.

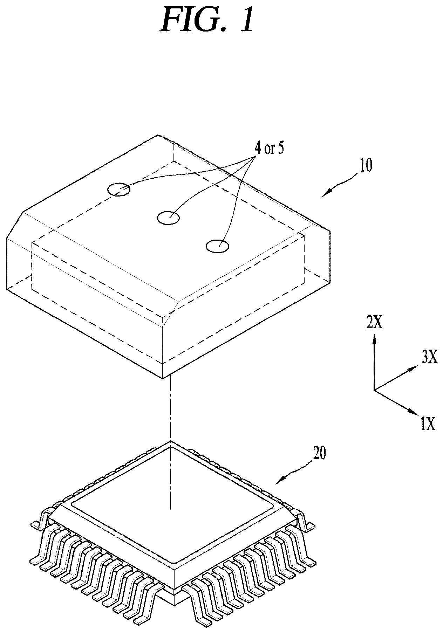

A configuration of a cold plate 10 can be as shown in FIG. 1.

The cold plate 10 is formed in a plate shape or pouch shape as shown in FIG. 1 to be arranged on a top of a cooling target 20.

Here, the cooling target 20 can be an electronic circuit element, a semiconductor element, or a computing device such as a CPU or GPU.

The cold plate 10 receives heat generated from the cooling target 20 from the top of the cooling target 20 to cool the received heat with a water-cooled heat sink formed thereinside.

The cold plate 10 includes an inlet 4 arranged on one surface through which coolant flows in, an outlet 5 arranged on the one surface through which the coolant flows out, and a cooling part 6 arranged in an internal space through which the coolant flows to exchange heat.

Here, the one surface can be a surface opposite to a surface with which the cooling target 20 comes into contact.

For example, when a lower surface -2X of the cold plate 10 in a form as shown in FIG. 1 comes into contact with a surface of the cooling target 20, an upper surface 2X of the cold plate 10 can become the one surface.

The one surface can also be one of surfaces having a largest area.

For example, in a form as shown in FIG. 1, either the upper surface 2X or the lower surface -2X can be the one surface.

The cold plate 10 is arranged to have the inlet 4 and the outlet 5 on the one surface, so that when the coolant flows into the cooling part 6 through the inlet 4, the coolant flows through the cooling part 6 to exchange heat with heat received from the cooling target 20, and the heat-exchanged coolant flows out through the outlet 5, thereby performing cooling for the heat generated from the cooling target 20.

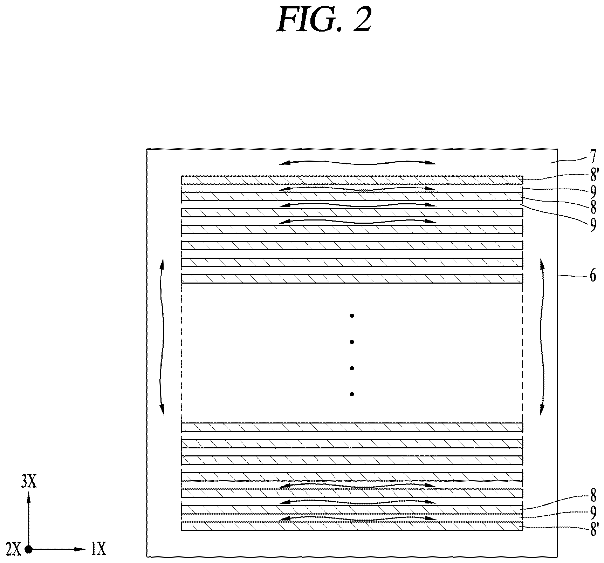

As such, a structure of the cooling part 6 through which the coolant flows can be as shown in FIG. 2.

The cooling part 6, as shown in FIG. 2, includes a side passage 7 arranged along a side of an inside thereof, a plurality of cooling fins 8 arranged at predetermined intervals in a region excluding the side passage 7, and a plurality of cooling passages 9 arranged at each of the predetermined intervals.

That is, the cooling part 6 can have the plurality of cooling fins 8 arranged at the predetermined intervals in an inner region thereof so as to allow the intervals between each of the plurality of cooling fins 8 to be formed as the plurality of cooling passages 9, and a region of the side excluding the region where the plurality of cooling fins 8 are arranged can be formed as the side passage 7.

Accordingly, the coolant can flow through the side passage 7 and the plurality of cooling passages 9 inside the cooling part 6.

Therefore, the coolant can flow through the plurality of cooling passages 9, that is, between the plurality of cooling fins 8 to come into contact with the plurality of cooling fins 8, thereby cooling heat generated from the plurality of cooling fins 8.

In this way, the cooling part 6 can be configured with a structure in which the side passage 7 and the plurality of cooling passages 9 are formed by the plurality of cooling fins 8, and the coolant circulates and flows therethrough.

Meanwhile, when the cooling part 6 is formed with the side passage 7, the plurality of cooling fins 8 and the plurality of cooling passages 9, the cooling fins arranged at the uppermost and lowermost ends of the plurality of cooling fins 8 can be arranged as partition fins 8' that separate between a region of the side passage 7 and a region where the plurality of cooling fins 8 are arranged.

When the cooling part 6 is formed in this structure, the inlet 4 and the outlet 5 can be arranged on the one surface according to the structure of the cooling part 6.

The inlet 4 can be arranged at a position corresponding to one of the side passage 7 and a central portion of the cooling part 6.

That is, the inlet 4 can be arranged at either one of a position corresponding to a region where the side passage 7 is arranged and a position corresponding to a region where the central portion of the cooling part 6 is arranged, on the one surface.

The inlet 4 can be arranged on either one of one end side and a center side of the one surface.

The outlet 5 can be arranged at a position corresponding to that of the side passage 7.

That is, the outlet 5 can be arranged at a position corresponding to a region where the side passage 7 is arranged on the one surface.

The outlet 5 can be arranged on one or more of the one end side and the other end side.

The inlet 4 and the outlet 5 can be arranged at different positions.

For example, when the inlet 4 is arranged on the one end side, the outlet 5 is arranged on the other end side, and when the inlet 4 is arranged on the center side, the outlet 5 can be arranged on one or more of the one end side and the other end side.

The cold plate 10 including the cooling part 6 can be arranged to have a structure in which a plurality of plates are stacked.

That is, the cold plate 10 can be configured with the plurality of plates.

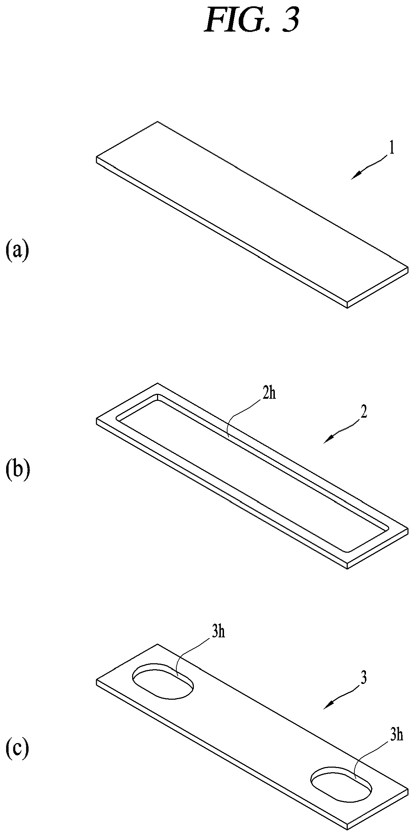

Shapes of the plurality of plates constituting the cold plate 10 can be as shown in FIG. 3.

The plurality of plates can include a first plate 1 ((a) of FIG. 3), a second plate 2 ((b) of FIG. 3), and a third plate 3 ((c) of FIG. 3) arranged in different shapes, as shown in (a), (b), and (c) of FIG. 3, respectively.

The first plate 1 cannot have a hole arranged.

The second plate 2 can have a passage hole 2h arranged in a region excluding a side thereof.

The passage hole 2h can be a hole that forms a passage through which the coolant flows toward a first axis 1X when the first plate 1 to the third plate 3 are stacked.

The passage hole 2h can be a hole arranged by the plurality of cooling passages 9 when the first plate 1 to the third plate 3 are stacked to constitute the cold plate 10.

That is, the second plate 2 can be a plate corresponding to the plurality of cooling passages 9 in the cold plate 10.

The third plate 3 can have a through hole 3h arranged on one or more of one end portion, the other end portion, and a central portion.

The through hole 3h can be a hole that forms a passage through which the coolant flows toward the third axis 3X when the first plate 1 to the third plate 3 are stacked.

The through hole 3h can be a hole arranged by the plurality of cooling fins 8 when the first plate 1 to the third plate 3 are stacked to constitute the cold plate 10.

That is, the third plate 3 can be a plate corresponding to the plurality of cooling fins 8 in the cold plate 10.

The third plate 3 can preferably have the through hole 3h arranged in each of the one end portion and the other end portion.

The first plate 1, the second plate 2, and the third plate 3 can be made of the same material.

The first plate 1, the second plate 2, and the third plate 3 can be processed from a metal (Cu, Al, STS, tungsten, titanium) or non-metal (plastic) material.

The first plate 1, the second plate 2, and the third plate 3 can be respectively processed through different processes.

The first plate 1, the second plate 2, and the third plate 3 can be processed to have the same length and width.

Accordingly, the first plate 1, the second plate 2, and the third plate 3 can be stacked in a form in which horizontal and vertical lengths thereof match during stacking.

Each of the first plate 1, the second plate 2, and the third plate 3 can be arranged to have a thickness within a reference thickness range.

Here, the reference thickness range can be, for example, 0.05 to 5 [mm].

That is, the first plate 1, the second plate 2, and the third plate 3 can be respectively arranged to have a thickness of 0.05 to 5 [mm].

The first plate 1, the second plate 2, and the third plate 3 can preferably be arranged to have at least two plates having the same thickness.

Accordingly, at least two sheets can be processed with one workpiece.

The first plate 1, the second plate 2 and the third plate 3 can preferably be arranged to have a thickness different from that of the first plate 1 and the second plate 2 and the third plate 3.

In this case, the first plate 1 can be arranged to have a thickness larger than that of the second plate 2 and the third plate 3.

Accordingly, when the first plate 1 is stacked to form uppermost and lowermost ends of the cold plate 10, a frame of the cold plate 10 can be formed to be thick.

The cold plate 10 can be formed by respectively stacking the first plate 1, the second plate 2, and the third plate 3 processed in different shapes as described above in plurality in a predetermined order.

That is, the first plate 1, the second plate 2, and the third plate 3 can be respectively processed in plurality in different shapes as shown in FIG. 3, and stacked in the predetermined order to form the cold plate 10.

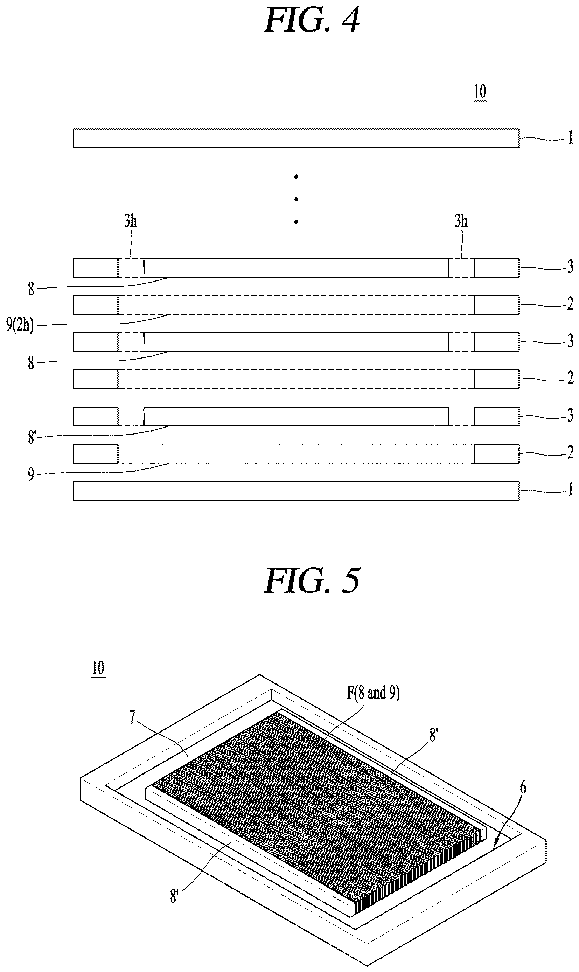

In this way, a stacked structure of the cold plate 10 formed by stacking the first plate 1, the second plate 2, and the third plate 3 can be as shown in FIG. 4.

The cold plate 10 can be formed by respectively stacking the first plate 1, the second plate 2, and the third plate 3 in plurality in the predetermined order, as shown in FIG. 4.

The cold plate 10 can be stacked to have the same vertical axis so as to allow side surfaces of the first plate 1 to the third plate 31 to match.

The cold plate 10 can be stacked to have the first plate 1 to the third plate 31 so as to allow the passage hole 2h of the second plate 2 and the through hole 3h of the third plate 3 to be positioned on the same vertical axis.

The cold plate 10 can be stacked with the first plate 1 to the third plate 3 so as to allow a first layer in which one more of the first plates 1 are stacked at lowermost and uppermost ends thereof to be arranged, a second layer in which one or more of the second plates 2 are stacked, and a third layer in which one or more of the third plates 3 are stacked to be arranged in an alternating manner between the lowermost and uppermost ends.

That is, the cold plate 10 can be stacked with the first plate 1 to the third plate 3 so as to allow the first layer to be arranged at one or more of the lowermost and uppermost ends, and the second layer and the third layer to be arranged in an alternating manner between the lowermost and uppermost ends.

Accordingly, the cold plate 10 can be arranged into a multi-layer structure in which the first layer, the second layer, and the third layer are respectively arranged in plurality.

Here, one or more of the first layers can be stacked with the plurality of first plates 1.

In addition, one or more of the third layers can also be stacked with the plurality of third plates 3.

Accordingly, the cold plate 10 can have a thickness (height) of two or more of the plurality of layer different from that of the other layers.

The cold plate 10 can have the plurality of first plates 11 stacked at one or more of the lowermost and uppermost ends.

Accordingly, the cold plate 10 can be formed such that one or more of the first layers have a thickness larger than that of the second layer and the third layer.

The cold plate 10 can have the plurality of second plates 2 stacked on one or more of a next layer from the lowermost end and a previous layer from the uppermost end.

Accordingly, the cold plate 10 can be formed such that one or more of the next layer from the lowermost end and the previous layer from the uppermost end have a thickness larger than the other layers of the second layer and the third layer.

In this way, the cold plate 10 formed by stacking the first plate 1 to the third plate 3 can be formed by stacking the first plate 1 on a portion of each of long sides and each of short sides.

In addition, the cold plate 10 can be formed by stacking the second plate 2 on a portion of each of the plurality of cooling passages 9 and each of the short sides.

In addition, the cold plate 10 can be formed by stacking the third plate 3 on a portion of each of the plurality of cooling fins 8 and of each of the short sides.

The cold plate 10 is formed by stacking the first plate 1 to the third plate 3 in this manner so as to allow a stacked structure of the first plate 1 to form upper and lower frames of the cold plate 10, a stacked structure in which the second plate 2 in which the passage hole 2h is formed and the third plate 3 in which the through hole 3h is formed are arranged in an alternating manner to form the cooling part 6, and side surfaces of each of the first plate 1 to the third plate 3 to form side frames of the cold plate 10.

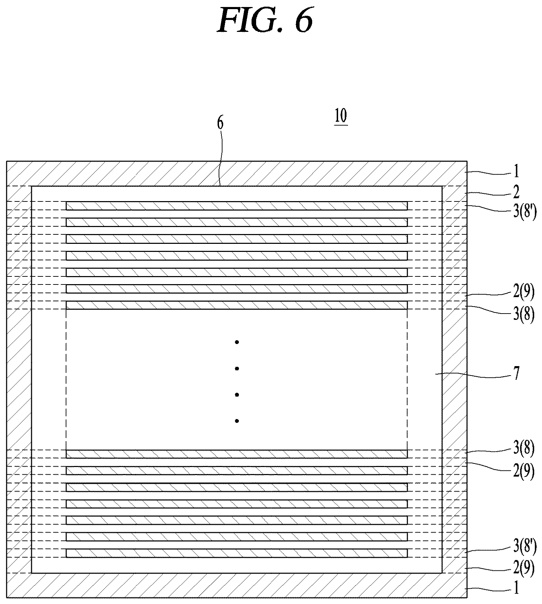

As such, an example of the cold plate 10 formed by stacking the first plate 1 to the third plate 3 can be as shown in FIGS. 5 and 6.

As shown in FIGS. 5 and 6, the cold plate 10 has the cooling part 6 formed thereinside excluding an outer frame so as to allow the coolant to flow in and out from the cooling part 6.

The cooling part 6 can be formed such that the side passage 7 is arranged along an inner side of the outer frame, the plurality of cooling fins 8 are arranged in a form of being raised between a surface that comes into contact with the cooling target 20 and a surface facing the cooling target 20, and the plurality of cooling passages 9 are arranged at intervals of the plurality of cooling fins 8, respectively.

The side passage 7 can have one passage extending along the side.

That is, the side passage 7 can be arranged in a form in which one passage extends along the side.

The side passage 7 can be arranged in a form in which passages of a left end, a right end, an upper end, and a lower end are each connected to one passage.

Here, the left end and the right end can be arranged by both ends of the passage hole 2h of the second plate 2 and the through hole 3h of the third plate 3, and the upper end and the lower end can be arranged by the passage hole 2h of the second plate 2.

The side passage 7 can be arranged to have a width larger than that of the plurality of cooling passages 9.

Accordingly, a flow rate of the coolant flowing along the side passage 7 can be greater than that of the plurality of cooling passages 9.

Therefore, the through hole 3h can be arranged to have a width larger than the predetermined interval, and the second layer corresponding to the next layer from the lowermost end and the previous layer from the uppermost end can be stacked in a number of the second plates 2 having a thickness larger than the predetermined interval.

The plurality of cooling fins 8 can be arranged to have a thickness of 0.1 to 2.0 [mm].

That is, the third layer can be stacked in a number of the third plates 3 having a thickness of 0.1 to 2.0 [mm].

In this case, preferably, the third plate 3 can be arranged to have a thickness of 0.1 to 2.0 [mm] so as to allow one third plate 3 to be stacked on each of the third layers.

Additionally, in this case, a thickness of the second plate 2 can also be arranged to have a thickness of 0.1 to 2.0 [mm].

The plurality of cooling fins 8 can be arranged to have a width of 1 to 20 [mm].

A width of the plurality of cooling fins 8 can refer to a height at which the plurality of cooling fins 8 are raised from the one surface to the other surface.

Meanwhile, when the width of the plurality of cooling fins 8 is as described above, the passage hole 2h of the second plate 2 and the through hole 3h of the third plate 3 can also be arranged to have a width of 1 to 20 [mm].

The plurality of cooling fins 8 can be arranged at equal intervals.

The plurality of cooling fins 8 can be arranged at intervals of 0.1 to 5.0 [mm].

That is, the plurality of cooling passages 9 can be arranged at intervals of 0.1 to 5.0 [mm].

Accordingly, the second layer can be stacked in a number of the second plates 2 having a thickness of 0.1 to 5.0 [mm].

In addition, the cooling part 6 has cooling fins arranged at the uppermost and lowermost ends respectively to form partitions 8' in a length direction so as to allow an inner side F of the partition and the side passage 7 to be separated from each other.

That is, among the plurality of cooling fins 8, the cooling fins arranged at the uppermost and lowermost ends can be formed as partition fins 8' that separate between the side passage 7 and the region F where the plurality of cooling fins 8 are arranged.

When the cooling part 6 is formed with this structure, the inlet 4 and the outlet 5 can be arranged on the one surface, thereby allowing the coolant to flow in and out.

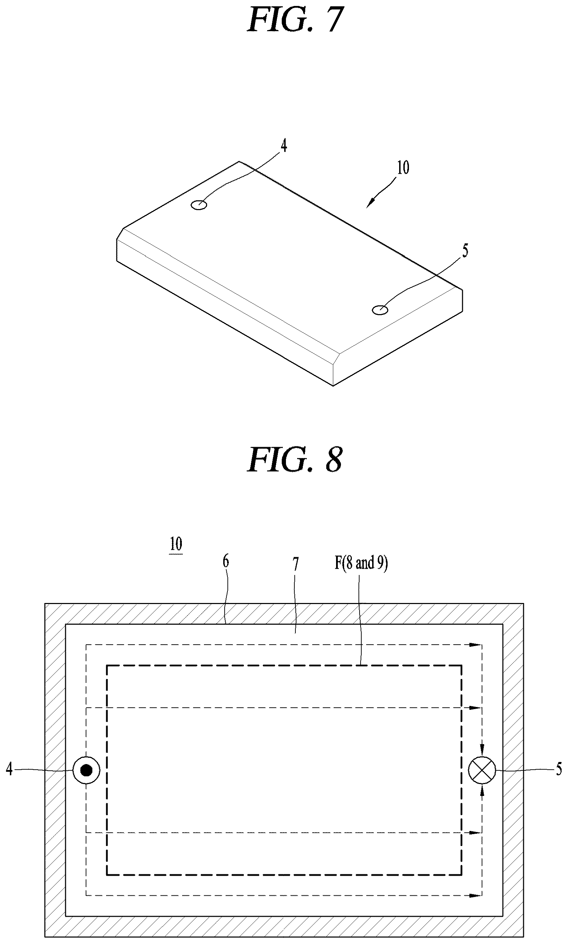

As such, when the cooling part 6 is formed, an example of arranging the inlet 4 and the outlet 5 and a resultant flow of the coolant can be as shown in FIGS. 7 and 8.

The cold plate 10 formed as shown in FIGS. 5 and 6 can have the inlet 4 and the outlet 5 respectively arranged at both ends of the one surface, as shown in FIG. 7.

Accordingly, the inflow and outflow of the coolant can be performed at a position corresponding to a region of the side passage 7, and thus the coolant can flow into the cooling part 6 as shown in FIG. 8.

In this case, the coolant can flow into one end of the cooling part 6 through the inlet 4, flow through the side passage 7 and the plurality of cooling passages 9, respectively, to the other end of the cooling part 6 where the outlet 5 is arranged, and then flow out through the outlet 5.

While the coolant flows in this way, heat is exchanged with the plurality of cooling fins 8 arranged on both sides of each of the plurality of cooling passages 9 so as to perform cooling for each of the plurality of cooling fins 8.

As such, the cold plate 10 can be configured such that the cooling part 6 has a structure as shown in FIGS. 5 and 6 so as to allow the coolant to flow and circulate throughout an entire interior of the cooling part 6, thereby achieving even cooling.

Accordingly, the cooling range and cooling efficiency of the cold plate 10 can be increased, thereby improving cooling performance.

Meanwhile, the cold plate 10 can change a passage structure of the cooling part 6 depending on the shape of the third plate 3.

For example, the shape of the third plate 3 can be processed differently so as to allow the region F where the plurality of cooling fins 8 are arranged to be divided into a plurality of regions, thereby adding the passages for the coolant.

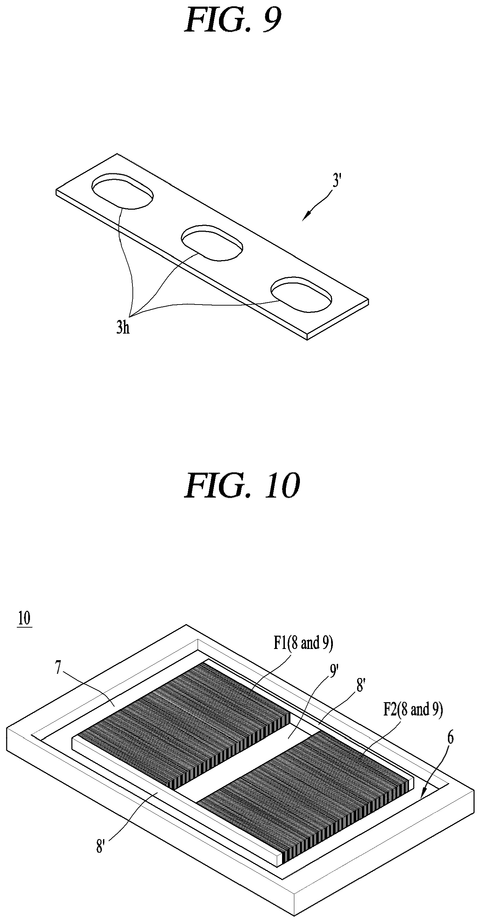

Another example of the third plate 3 can be as shown in FIG. 9.

Another example 3' of the third plate 3 (hereinafter, another plate) can further have a through hole 3h arranged in the central portion, as shown in FIG. 9.

That is, the other plate 3' can further have the through hole 3h arranged in the central portion in a form in which the through holes 3h are arranged in the one end portion and the other end portion.

When the other plate 3' is stacked, each of the plurality of cooling fins 8 can be separated into two regions based on the central axis by the through hole 3h arranged in the central portion.

Accordingly, an additional passage can be further formed along the separated central axis.

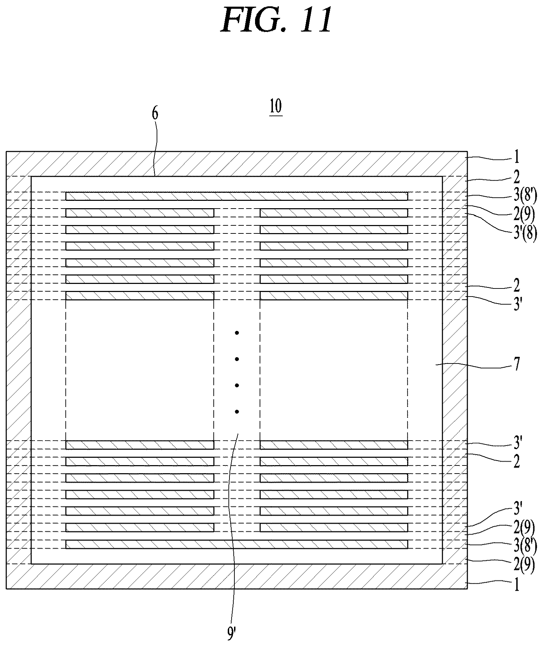

An example of the cold plate 10 formed by further stacking the other plate 3' as shown in FIG. 9 can be as shown in FIGS. 10 and 11.

The cold plate 10 formed by the other plate 3' can be arranged such that the region F where the plurality of cooling fins 8 are arranged is divided into two regions, a first region F1 and a second region F2, as shown in FIGS. 10 and 11.

The cooling part 6 can further include a central passage 9' arranged along the central axis of the cooling fins arranged between the uppermost and lowermost ends 8' of the plurality of cooling fins 8, through which the central axis of the cooling fins passes.

That is, the cooling part 6 can be formed such that the central axis of the cooling fins arranged between the uppermost and lowermost ends 8' of the plurality of cooling fins 8 is passed by the through hole 3h arranged in the central portion of the other plate 3' so as to allow the central passage 9' to be arranged along the central axis.

Accordingly, the cooling part 6 can be further formed by the central passage 9' corresponding to a space between the first region F1 and the second region F2 so as to allow the coolant to flow through the side passage 7, the plurality of cooling passages 9, and the central passage 9'.

The central passage 9' can be arranged to have a width larger than that of the plurality of cooling passages 9.

Accordingly, a flow rate of the coolant flowing along the central passage 9' can be greater than that of the plurality of cooling passages 9.

Therefore, the through hole 3h arranged in the central portion can be arranged to have a width larger than the predetermined interval.

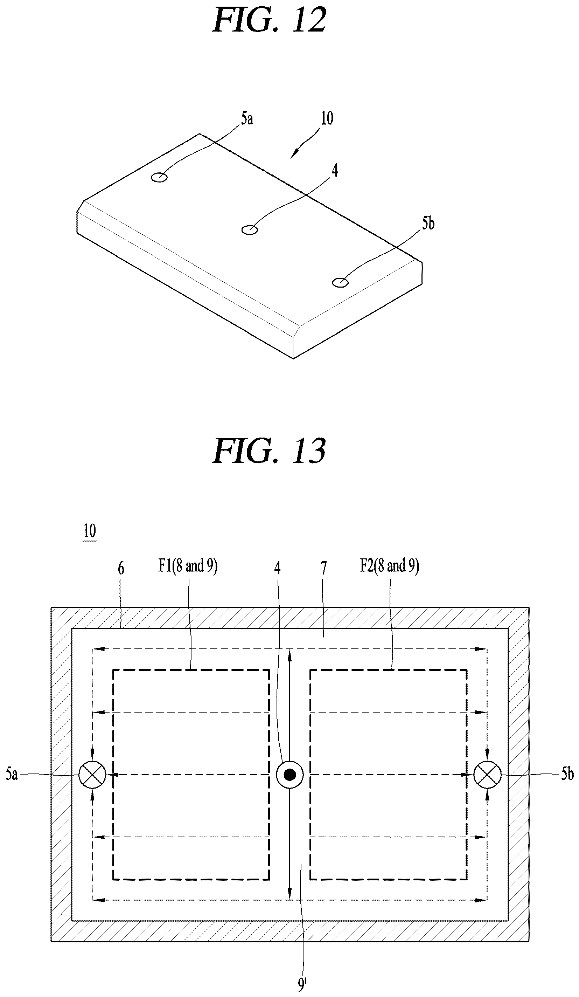

When the cooling part 6 is formed in this manner, an example of arranging the inlet 4 and the outlet 5 and a resultant flow of the coolant can be as shown in FIGS. 12 and 13.

The cold plate 10 formed as shown in FIGS. 10 and 11 can have the inlet 4 arranged on the center side of the one surface, and the outlets 5a, 5b respectively arranged on both ends of the one surface, as shown in FIG. 12.

Accordingly, the inflow of the coolant can be performed at a position corresponding to a region of the central passage 9', and the outflow of the coolant can be performed at a position corresponding to a region of the side passage 7 so as to allow the coolant to flow into the cooling part 6 as shown in FIG. 13.

In the cooling part 6, when the coolant flows therein, the coolant can flow through the central passage 9' and branch off into the plurality of cooling passages 9, respectively, and then flow into the side passage 7.

In this case, the coolant can flow into a center side of the cooling part 6 through the inlet 4, flow through the central passage 9' and the plurality of cooling passages 9, respectively, to both ends, respectively, of the cooling part 6 where the outlets 5a and 5b are arranged, and then flow out through the outlets 5a, 5b, respectively.

Accordingly, the coolant can flow in a manner of diffusing from the center side of the cooling part 6 to the side passage 7 through the central passage 9' and the plurality of cooling passages 9, respectively.

In particular, heat conducted from the cooling target 20 can be concentrated to allow the coolant to flow into the center side where the temperature is relatively higher than that of the side, thereby effectively performing cooling for the central side where the temperature is higher as well as achieving temperature balance (cooling balance/heat dissipation balance) within the cold plate 10.

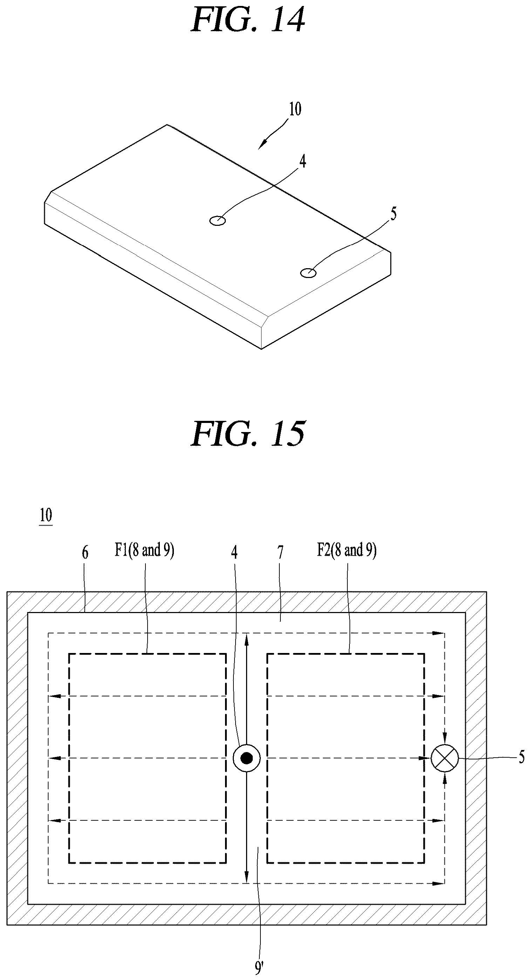

In addition, when the cooling part 6 is formed as shown in FIGS. 10 and 11, another example of arranging the inlet 4 and the outlet 5 and a resultant flow of the coolant can be as shown in FIGS. 14 and 15.

The cold plate 10 formed as shown in FIGS. 10 and 11 can have the inlet 4 arranged on the center side of one surface, and the outlet 5 arranged on either one (the other end) of both ends of the one surface, as shown in FIG. 14.

Accordingly, the inflow of the coolant can be performed at a position corresponding to a region of the central passage 9', and the outflow of the coolant can be performed at a position corresponding to a region of the side passage 7 so as to allow the coolant to flow into the cooling part 6 as shown in FIG. 15.

In the cooling part 6, when the coolant flows therein, the coolant can flow through the central passage 9' and branch off into the plurality of cooling passages 9, respectively, and then flow into the side passage 7.

In this case, the coolant can flow into the center side of the cooling part 6 through the inlet 4, flow through the central passage 9', the plurality of cooling passages 9, and the side passages 7, respectively, to the other end of the cooling part 6 where the outlet 5 is arranged, and then flow out through the outlet 5.

The cold plate 10 as described above can be coupled to (mounted on, provided with) a plurality of components for use by being mounted on the cooling target 20 subsequent to arranging the inlet 4 and the outlet 5 thereon.

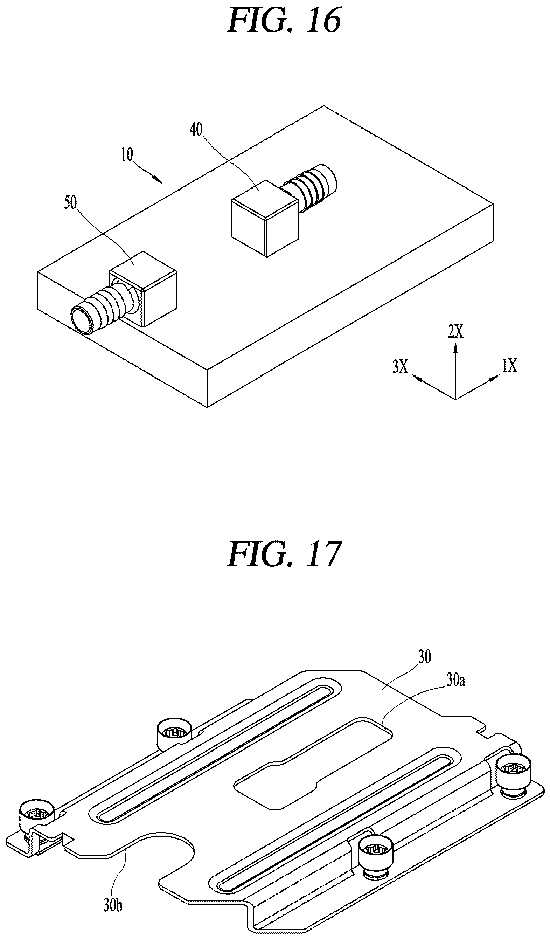

Examples of a plurality of components of the cold plates 10 and coupling thereto can be as shown in FIGS. 16 to 18.

As shown in FIG. 16, the cold plate 10 can be coupled to an inlet nipple 40 and an outlet nipple 50 for the inflow and outflow of the coolant at the inlet 4 and the outlet 5, respectively.

Each of the inlet nipple 40 and the outlet nipple 50 can be connected to a tube of the coolant to receive and supply the coolant through the tube.

The cold plate 10 can have a bracket 30 coupled to the one surface thereof, as shown in FIG. 17.

The bracket 30 can correspond to a cover that protects the one surface, and can also correspond to a heat conductor that conducts and dissipates heat radiated from the one surface.

The bracket 30 can be arranged in a shape that covers at least two-thirds of an area of the one surface.

In addition, the bracket 30 can have arrangement grooves 30a, 30b in which the inlet nipple 40 and the outlet nipple 50 are respectively arranged when coupling to the one surface.

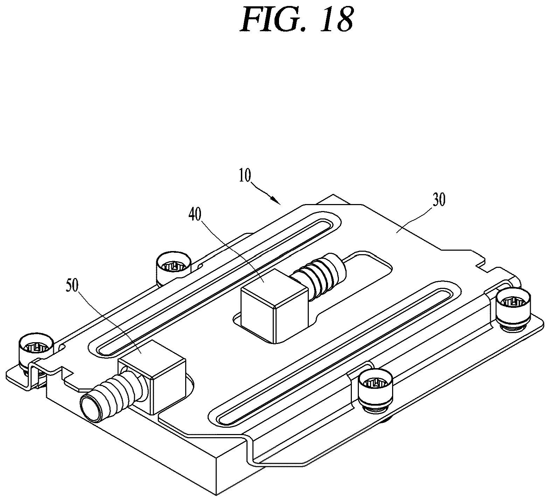

The cold plate 10 can be mounted on the cooling target 20 in a form as shown in FIG. 18 by being coupled to the bracket 30, the inlet nipple 40, and the outlet nipple 50.

Meanwhile, the cold plate 10 as described above can be manufactured in plurality in a single process by stacking and then cutting a plate in which the first plate 1, the second plate 2, and the third plate 3 are respectively arranged in plurality as shown in FIG. 3.

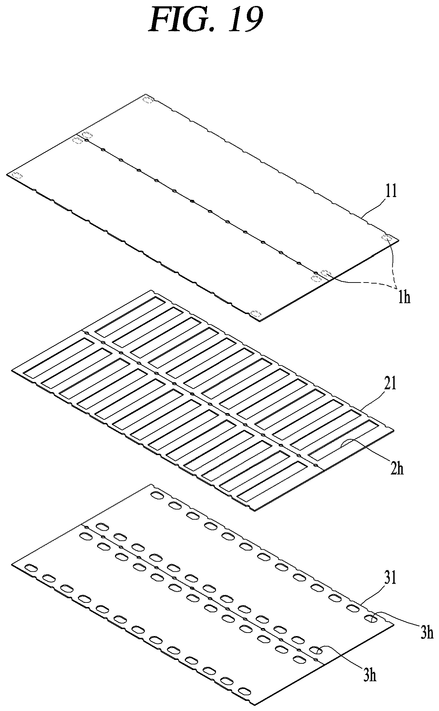

A process of manufacturing a plurality of cold plates 10 in this way can be as shown in FIGS. 19 to 22.

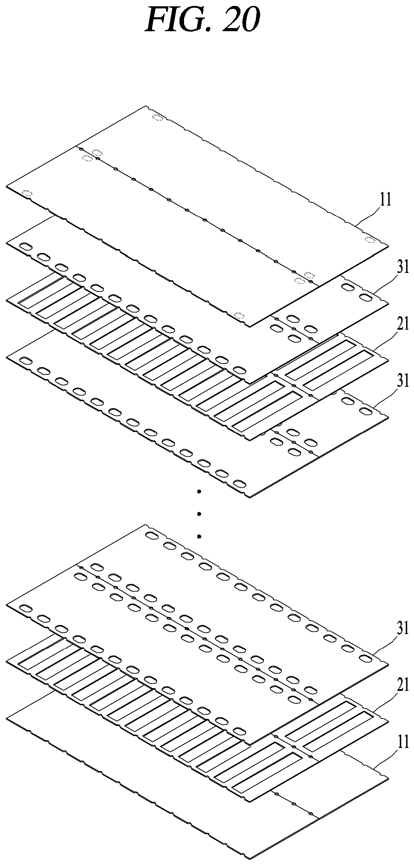

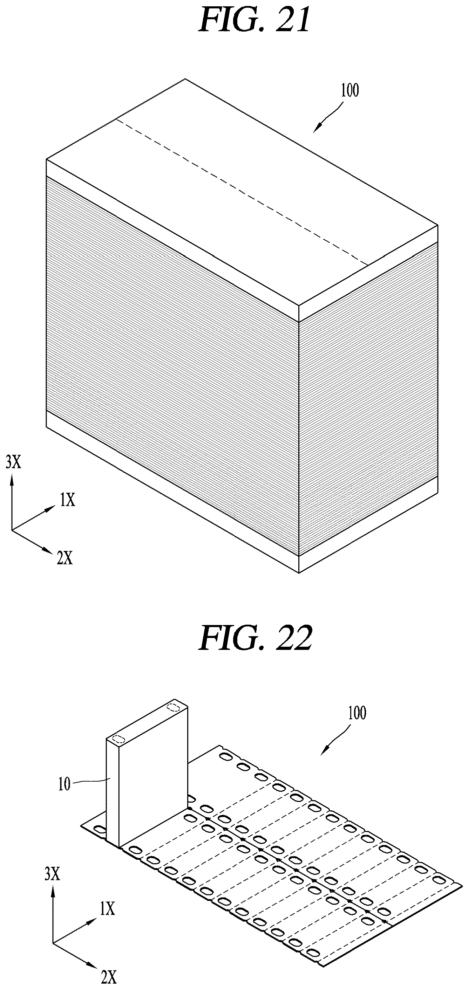

The process of manufacturing the plurality of cold plates 10 can include forming a plurality of plates 11, 21, 31 in which the first plate 1, the second plate 2, and the third plate 3 are respectively arranged in plurality as shown in FIG. 19, respectively stacking the plurality of plates 11, 21, 31 in plurality in the predetermined order as shown in FIG. 20, bonding a stacked body 100 in which the plurality of plates 11, 21, 31 are stacked as shown in FIG. 21, and then cutting the stacked body 100 according to an arrangement unit of the plurality of plates 11, 21, 31 to respectively process the cut bodies 10 as shown in FIG. 22 to manufacture the plurality of cold plates 10.

The plurality of plates 11, 21, 31 can respectively be plates in which the first plate 1, the second plate 2, and the third plate 3 are respectively arranged in a plurality of rows and a plurality of columns, as shown in FIG. 19.

The plurality of plates 11, 21, 31 can be respectively stacked in plurality in the predetermined order so as to allow the plurality of cold plates 10 to be manufactured in a number corresponding to the arrangement unit.

The plurality of plates 11, 21, 31 can be stacked so as to allow side surfaces thereof to match.

The plurality of plates 11, 21, 31 can be stacked such that, as shown in FIG. 20, a first arrangement plate 11 in which the first plate 1 is arranged at lowermost and uppermost ends, a second arrangement plate 21 in which the second plate 2 is arranged and a third arrangement plate 31 in which the third plate 3 is arranged are arranged in an alternating manner between the lowermost and uppermost ends.

Accordingly, a stacking structure of the first arrangement plate 11 can form upper and lower frames of the stacked body, a stacked structure in which the second arrangement plate 21 in which the passage hole 2h is formed and the third arrangement plate 31 in which the through hole 3h is formed are arranged in an alternating manner can form a passage structure inside the stacked body 100, and side surfaces of each of the first arrangement plate 11 to the third arrangement plate 31 can form side frames of the stacked body 100.

Here, the first arrangement plate 11 to the third arrangement plate 31 can respectively have one or more plates stacked on a layer to be stacked.

For example, the first arrangement plate 11 can be stacked in plurality on each of the lowermost and uppermost ends, or the second arrangement plate 21 can be stacked in plurality on one or more of a plurality of layers in which the second arrangement plate 21 is arranged.

Accordingly, a thickness (height) of one or more of a plurality of stacked layers of the stacked body 100 can be different from that of the other layers.

The stacked body 100 can be aligned so as to allow side surfaces thereof to match prior to coming into contact with one another.

As shown in FIG. 21, the stacked body 100 can be aligned so as to allow the plurality of plates 11, 21, 31 to match on the same vertical axis.

The stacked body 100 can be bonded subsequent to allowing respective side surfaces of the plurality of plates 11, 21, 31 to be aligned to have a flat shape.

The stacked body 100 can be bonded by a diffusion bonding method at portions in which the plurality of plates 11, 21, 31 respectively come into contact with one another.

That is, the plurality of cold plates 10 can be respectively formed by bonding the first plate 1, the second plate 2, and the third plate 3 using a diffusion bonding method.

Here, the diffusion bonding means a method of bonding without defects such as pores by using the principle of diffusion of atoms occurring between the bonding surfaces by bringing two parts into close contact with each other under appropriate heating and pressurization conditions within the required range and heating them to a temperature below their melting points.

The stacked body 100 can also be bonded by a brazing bonding method at overlapping portions of the plurality of plates 11, 21, 31.

The stacked body 100 can also be bonded, when the plurality of plates 11, 21, 31 are made of a non-metallic material, by an adhesive bonding method or an ultrasonic fusion method at the overlapping portions of the plurality of plates 11, 21, 31.

The stacked body 100 can be separated into a plurality of cut bodies 10 by cutting a portion where the plurality of plates 11, 21, 31 are bonded except for edge portions thereof.

The stacked body 100 can be cut along one or more of a first axis 1X corresponding to a length direction and a second axis 2X corresponding to a width direction, and along a third axis 3X corresponding to a height direction, as shown in FIG. 22.

The stacked body 100 can be cut along the third axis 3X according to the arrangement unit.

For example, when the arrangement unit is arranged in a matrix of ten rows by two columns, it can be cut along the third axis 3X along the respective nine cut rows corresponding to between the respective ten rows and along one cut column corresponding to between the respective two columns.

Accordingly, the stacked body 100 can be separated into 20 cut bodies 10.

Then, the cut bodies 10 can be respectively processed to arrange the inlet 4 and the outlet 5, and then the bracket 30, the inlet nipple 40 and the outlet nipple 50 can be coupled to the plurality of cold plates 10, respectively, so as to complete the manufacturing of the plurality of cold plates 10.

Therefore, the plurality of cold plates 10 can be manufactured in a single manufacturing process by stacking the plurality of plates 11, 21, 31.

Although the embodiment of the cold plate has been described so far, the described embodiments can be modified in various ways without departing from the scope of the present disclosure, and the scope of the present disclosure is not limited to the described embodiments.

## Claims

1. A cold plate comprising:
an inlet arranged on one surface through which coolant flows in;
an outlet arranged on the one surface through which the coolant flows out; and
a cooling part arranged in an internal space thereof through which the coolant flows to exchange heat,
wherein the cooling part comprises:
a side passage arranged along a side of an inside thereof;
a plurality of cooling fins arranged at predetermined intervals in a region excluding the side passage; and
a plurality of cooling passages arranged at the predetermined intervals, respectively.

2. The cold plate of claim 1, wherein the one surface is a surface opposite to a surface with which a cooling target comes into contact.

3. The cold plate of any one of claims 1 and 2, wherein the inlet is arranged at a position corresponding to one of the side passage and a central portion of the cooling part.

4. The cold plate of any one of claims 1 to 3, wherein the outlet is arranged at a position corresponding to that of the side passage.

5. The cold plate of any one of claims 1 to 4, wherein first, second, and third plates processed in different shapes are respectively formed by stacking them in plurality in a predetermined order.

6. The cold plate of claim 5, wherein a portion of each of long sides and each of short sides is formed by stacking the first plate.

7. The cold plate of claim 5, wherein a portion of each of the plurality of cooling passages and each of the short sides are formed by stacking the second plate.

8. The cold plate of claim 5, wherein a portion of each of the plurality of cooling fins and each of the short sides are formed by stacking the third plate.

9. The cold plate of any one of claims 1 to 8, wherein the side passage has one passage extending along the side and is arranged to have a larger width than the plurality of cooling passages.

10. The cold plate of any one of claims 1 to 9, wherein the plurality of cooling fins are arranged to have a thickness of 0.1 to 2.0 [mm].

11. The cold plate of any one of claims 1 to 10, wherein the plurality of cooling fins are arranged to have a width of 1 to 20 [mm].

12. The cold plate of any one of claims 1 to 11, wherein the plurality of cooling fins are arranged at intervals of 0.1 to 5.0 [mm].

13. The cold plate any one of claims 1 to 12, wherein in the cooling part, cooling fins arranged at uppermost and lowermost ends respectively build partitions in a length direction so as to separate between an inner side of the partition and the side passage.

14. The cold plate of any one of claims 1 to 13, wherein the cooling part further comprises:
a central passage arranged along a central axis of the cooling fins arranged between uppermost and lowermost ends of the plurality of cooling fins by passing through the central axis, and
wherein the central passage is arranged to have a larger width than the plurality of cooling passages.

15. The cold plate of claim 14, wherein in the cooling part, when the coolant flows therein, the coolant flows through the central passage, branches off into the plurality of cooling passages, respectively, and then flows into the side passage.
